# EUROPÄISCHE PATENTSCHRIFT

(11) **EP 0 422 386 B1**
(45) Veröffentlichungstag und Bekanntmachung des Hinweises auf die Patenterteilung: **18.01.1995**
(21) Anmeldenummer: 90117059.7
(22) Anmeldetag: 05.09.1990
(51) Int. Cl.: C01G 3/00, C04B 35/00, H01L 39/24

(54) **Verfahren zur Herstellung eines Supraleiters aus einem Oxalat**
Process for preparing a superconductor based on oxalate
Procédé de préparation d'un supraconducteur à base d'oxalate

(30) Priorität: 09.09.1989 DE 3930113
(43) Veröffentlichungstag der Anmeldung: 17.04.1991
(73) Patentinhaber: HOECHST AKTIENGESELLSCHAFT, 65926 Frankfurt am Main (DE)
(72) Erfinder: Becker, Winfried, Dr., D-6233 Kelkheim (Taunus) (DE)

(56) Entgegenhaltungen:
- EP-A- 0 287 064
- EP-A- 0 303 249
- EP-A- 0 313 148
- JOURNAL OF THE AMERICAN CERAMIC SOCIETY. vol. 72, no. 4, April 1989, COLUMBUS US Seiten 696-698; K.W. Lay: "Formation of Yttrium Barium Cuprate Powder at Low Temperatures"

## Beschreibung

Die vorliegende Erfindung betrifft ein Verfahren zur Herstellung eines phasenreinen, Kupfer enthaltenden, oxidkeramischen Supraleiters, der neben Kupfer noch mindestens eine Erdalaklimetall (Ba, Sr, Ca) und mindestens ein Metall ausgewählt aus der Gruppe Y, La, Tl, Pb oder der Seltenen Erden enthält, durch quantitative Copräzipitation der Metalloxalate aus entsprechend eingestellten Lösungen und deren gezielte Zersetzung.

Die Herstellung von YBa₂Cu₃O₇₋ₓ-Keramiken wird erstmals in Physical Review Letters, Bd. 58 (1987), Seite 908 beschrieben. Nach diesem Verfahren werden die Ausgangsverbindungen Y₂O₃, BaCO₃ und CuO gut vermengt. Das Gemenge wird gepreßt, danach über mehrere Stunden bei 950°C gesintert und schließlich im Sauerstoffstrom langsam auf Raumtemperatur abgekühlt. In der Folge wurde gefunden, daß Sintertemperatur, Abkühlungsrate und Gasatmosphäre die physikalischen Eigenschaften des erhaltenen Körpers, insbesondere die für die Supraleitung verantwortlichen, erheblich beeinflussen.

Trotz großen experimentellen Aufwandes zur Optimierung der Darstellungsbedingungen ist die Situation hinsichtlich der Gewinnung phasenreiner Pulver oder Keramiken immer noch unbefriedigend. Als häufigste Nebenphasen wurden BaCuO₂, Y₂BaCuO₅ und CuO für YBa₂Cu₃O₇₋ₓ identifiziert. Ähnliche Probleme bestehen auch bei der Herstellung anderer Kupfer enthaltender oxidkeramischer Supraleiter.

Um örtliche Inhomogenitäten zu vermeiden, die sich möglicherweise durch Sintern der Oxide nicht genügend beseitigen lassen, hat man schon versucht, metallhaltige Ausgangsmaterialien durch Copräzipitation zu erhalten.

Aus EP 303 249 ist ein Verfahren zur Herstellung von YBa₂Cu₃Oₓ-Supraleitern bekannt, bei dem man eine wäßrige Lösung, die die Nitrate von Y, Ba und Cu im Atomverhältnis von Y:Ba:Cu = 1:2:3 enthält, mit Oxalat ausfällt. Das Oxalat wird isoliert und zunächst bei 700°C bei einem Sauerstoff-Partialdruck von 0,01 Torr und dann als Formkörper bei 850°C oder 900°C in Sauerstoff gebrannt. Dabei können bei Co-Präzipitaten, die aus wäßriger Lösung gefällt werden, wegen der in der Regel unterschiedlichen Löslichkeiten der ausgefällten Salze im Wasser Schwierigkeiten auftreten (Solid State Communications Bd. 64 (1987), Seite 881).
Gemäß US-Patent 4 804 649 wird durch Copräzipitation aus einer wäßrigen Lösung, die Salze von Y, Ba und Cu enthält, mit alkalischer Oxalatlösung ein basisches Oxalat erhalten.

Es wurde beobachtet, daß bei der Zersetzung der Oxalate in Gegenwart von Sauerstoff auch BaCO₃ gebildet wird, das erst über 1400°C einen Dissoziationsdruck von 1 bar erreicht. Dies erschwert die Bildung von YBa₂Cu₃O₇₋ₓ, da sich YBa₂Cu₃O₆ schon oberhalb 950°C merklich zersetzt. Daher muß man lange Glühzeiten zur Herstellung des Supraleiters in Kauf nehmen.

Es bestand daher die Aufgabe, die thermische Zersetzung der Oxalate zu den Oxiden so vorzunehmen, daß ein möglichst reines, sinteraktives Oxidgemisch anfällt, mit dem die Weiterreaktion zum Supraleiter, insbesondere zu YBa₂Cu₃O₇₋ₓ leicht erfolgt.

Es wurde nun ein Verfahren zur Herstellung eines kupferhaltigen, oxidkeramischen Supraleiters, der neben Kupfer noch mindestens ein Erdalkalimetall und mindestens ein Metall ausgewählt aus der Gruppe Y, Tl, Pb, La oder der Seltenen Erden enthält, gefunden, bei dem man eine Lösung bereitet, die die Metallanteile des Supraleiters in den berechneten Mengen in Form löslicher Salze enthält, man durch Vereinigung mit einer Oxalsäurelösung die Metalle als Oxalat ausfällt, man das Gemisch der Oxalate abtrennt, trocknet, durch thermische Zersetzung in die Oxide umwandelt, anschließend in Gegenwart von Sauerstoff bei 700 - 950°C sintert und in den Supraleiter überführt. Das Verfahren ist dadurch gekennzeichnet, daß das Erhitzen des Metalloxalats und der daraus gebildeten Oxide bis 700°C bei einem Sauerstoffpartialdruck von maximal 50 mbar, insbesondere 5 - 50 mbar, in Anwesenheit eines Inertgases, wie z.B. Argon oder Stickstoff, bei einem Absolutdruck von 0,5 - 2 bar, insbesondere 0,8 - 1,2 bar, vorzugsweise Normaldruck, erfolgt.

Beim anschließenden Erhitzen oberhalb 700°C in Gegenwart von O₂ werden Spuren von freiem Kohlenstoff oder freien Metallen leicht in die Oxide umgewandelt, ohne daß BaCO₃ auftritt.

Unter diesen Bedingungen bildet sich kein BaCO₃. Wenn der O₂-Partialdruck unter 5 mbar absinkt, tritt freier Kohlenstoff auf. Dann ist es vorteilhaft, das weitere Aufheizen bis 700°C in einem Gasgemisch mit einem Sauerstoffpartialdruck von 1 - 50 mbar, insbesondere 5 - 50 mbar vorzunehmen. Das Sintern erfolgt vorzugsweise unter reinem Sauerstoff.

Das zunächst gebildete YBa₂Cu₃O₆ geht bei der thermischen Nachbehandlung in Gegenwart von O₂ bei niedrigerer Temperatur in YBa₂Cu₃O₇₋ₓ über.

Das Sintern unter Bildung von YBa₂Cu₃O₆-Pulver kann vorzugsweise bei 800 - 900°C, inbesondere bei 800 - 850°C erfolgen, da das Fehlen von BaCO₃ ein Absenken der Reaktionstemperatur erlaubt. Dies führt zu einer Verringerung von störenden Fremdphasen und zu feineren Pulvern.

Gepreßte Formkörper aus dem durch Zersetzen von Oxalat gewonnenen Pulver können bei 850 - 900°C während mindestens 12 Stunden im Sauerstoffstrom gesintert werden.

Sowohl das bei über 700°C mit Sauerstoff behandelte Pulver oder ein daraus hergestellter Formkörper werden beim Tempern in Sauerstoffatmosphäre bei 400 - 500°C, vorzugsweise während mindestens 5 Stunden, supraleitend.

Ähnliche Ergebnisse werden erhalten, wenn Y ganz oder teilweise durch La, Tl, Pb oder ein Seltenes Erdmetall und Barium ganz oder teilweise durch Strontium oder Calcium ersetzt werden.

Das angegebenen Verfahren eignet sich insbesondere zur Herstellung von oxidkeramischen Supraleitern, die kein Wismut enthalten, vorzugsweise zur Herstellung von YBa₂Cu₃O_{Z}, aber auch zur für LaBa₂Cu₃O_{Z}, LnBa₂Cu₃O_{Z} (wobei Ln für ein Element der Seltenen Erden steht), Y₁₋ₓCaₓBa₂Cu₃O₇, YSr₂Cu₃O₇, La₁₊ₓBa₂₋ₓCu₃O₇, La₂₋ₓSrₓCuO₄, Tl₂Ba₂CaCuO₈, Tl₂Ba₂Ca₂Cu₃O₁₀, Tl₂Ba₂₋ₓSrₓCaCu₂O₈, TlBa₂Cu₃O₉, Pb₂Sr₂Ca₁₋ₓYₓCu₃O₈.

Man kann zur Gewinnung des Oxalats einmal eine Lösung der Metallsalze in einem mit Wasser mischbaren organischen Lösemittel einsetzen, beispielsweise eine Lösung von YCl₃, CuCl₂ und Ba(ClO₄)₂ in Ethanol und diese Lösung mit einer alkoholischen oder wäßrigen Oxalsäurelösung vereinigen. Man kann aber auch eine wäßrige Lösung einsetzen, die die Metallkationen enthält, und, vorzugsweise bei erhöhter Temperatur, mit einer Lösung der Oxalsäure, Wasser oder in einem mit Wasser mischbaren organischen Lösemittel vereinigen und dadurch die Oxalate ausfällen. Als Salze eignen sich, je nach Löslichkeit, z.B. die Chloride, Sulfate, Zitrate oder Nitrate. Auch das Oxalat von Tl (1) ist schwer löslich. Die Oxalate sind in den mit Wasser mischbaren organischen Lösemitteln, z.B. Alkohol, Methanol, Aceton, noch schwerer löslich als in Wasser.

Der entstandene hellblaue Niederschlag wird zunächst mit kaltem Wasser oder einem mit Wasser mischbarem organischen Lösemittel, beispielsweise Ethanol, gewaschen und getrocknet.

Die thermische Zersetzung des Oxalats wird bei Temperaturen von 200 bis 400 °c in einer Gasatmosphäre durchgeführt, die einen O₂-Partialdruck von 0 bis 5 mbar aufweist, und das anschließende Erhitzen der gebildeten Oxide bis 700 °C erfolgt bei einem Sauerstoffpartialdruck von maximal 50 mbar, insbesondere 5 bis 50 mbar. Die anschließende Reaktion zum Supraleiter, bei gepreßten Formkörpern unter Sintern, erfolgt bei 800-900°C, vorzugsweise bei 800-850°C, im Sauerstoffstrom. Das Sintern eines Preßkörpers aus YBa₂Cu₃O₇ setzt nach dilatometrischen Untersuchungen bei 800°C ein, d.h. um 100 K tiefer als bei herkömmlichen Proben.

Die nach dem angegebenen Verfahren synthetisierten Supraleiter-Pulver wurden mit röntgenographischen Pulvermethoden und analytischer Gehaltsbestimmung mit Hilfe der Mikrosonde als phasenrein identifiziert. Sie sind sehr feinkörnig. Ihre Primärteilchengröße liegt unter 1 »m.

### Beispiel

22.5 mMol Y(NO₃)₃·5H₂O, 45 mMol Ba(NO₃)₂ und 67,5 mMol Cu(NO₃)₂·3H₂O wurden in 200 ml Wasser gelöst und die Lösung mit Hilfe von Ultraschall während etwa 2,5 Stunden zerstäubt. Hierzu wurde die in der DE-OS 3 632 396 beschriebene Apparatur verwendet.

In einer Entfernung von ca. 5 cm unterhalb des Ultraschallzerstäubers befand sich in einem Becherglas eine kräftig gerührte Lösung von 293 mMol Oxalsäure in 1 l Ethanol. Nach Beendigung der Zerstäubung wurde der entstandene Niederschlag vom Ethanol abzentrifugiert und im Trockenschrank 4 Stunden bei 110°C getrocknet. Nach einer chemischen Analyse betrug das Atomverhältnis 0,99 Y:1,99 Ba:3 Cu, was mit der berechneten Zusammensetzung bei Berücksichtigung der Analysengenauigkeit übereinstimmt.

Zur Calcinierung und Umwandlung der Oxide in den Supraleiter wurde das getrocknete Pulver in einer Atmosphäre von 20 mbar O₂ und 980 mbar N₂ in 10 Stunden auf 400°C aufgeheizt, 5 Stunden bei 400°C gehalten, dann in 4 Stunden auf 900°C aufgeheizt. Dann wurde während 6 Stunden bei dieser Temperatur in reinem O₂ gehalten. Anschließend wurde in 6 Stunden auf Raumtemperatur in reinem O₂ abgekühlt.

Das Pulver wurde anschließend noch 10 Stunden bei 400°C unter Sauerstoffatmosphäre nachgetempert, um den Sauerstoffgehalt auf den für die Supraleitung erforderliche Höhe zu bringen. Die Sprungtemperatur beträgt 92 K.

Das Pulver wurde zu einer Tablette gepreßt und diese in Sauerstoff während 4 Stunden auf 900°C aufgeheizt, 6 Stunden bei 900°C gehalten, in 6 Stunden auf 400°C abgekühlt, weitere 10 Stunden bei 400°C gehalten und dann dem Ofen entnommen. Die Tablette zeigte eine kritische Stromdichte von 501.5 A/cm². Die zerkleinerte Tablette besteht nach röntgenographischen Untersuchungen aus phasenreinem YBa₂Cu₃O₇₋ₓ.

## Patentansprüche

1. Verfahren zur Herstellung eines phasenreinen Kupfer enthaltenden oxidkeramischen Supraleiters, der neben Kupfer noch mindestens ein Erdalkalimetall der Gruppe Ba, Sr, Ca und mindestens ein Metall der Gruppe Y, La, Tl, Pb oder der Seltenen Erden enthält,
wobei man eine Lösung bereitet, die die Metallanteile in den Atomverhältnissen des Supraleiters enthält, man durch Vereinigung mit einer Oxalsäurelösung die Metalle als Oxalat ausfällt, man das Gemisch der Oxalate abtrennt, trocknet, zu den Oxiden zersetzt und anschließend in Gegenwart von Sauerstoff bei Temperaturen von 700 bis 900°C sintert und in den Supraleiter überführt, dadurch gekennzeichnet, daß das Erhitzen des Metalloxalats und der daraus gebildeten Oxide bis 700°C bei einem Sauerstoffpartialdruck von 5 bis 50 mbar in Anwesenheit eines Inertgases und bei einem Absolutdruck im Bereich von 0,5 bis 2 bar erfolgt.

2. Verfahren zur Herstellung eines phasenreinen Kupfer enthaltenden oxidkeramischen Supraleiters, der neben Kupfer noch mindestens ein Erdalkalimetall der Gruppe Ba, Sr, Ca und mindestens ein Metall der Gruppe Y, La, Tl, Pb oder der Seltenen Erden enthält, wobei man eine Lösung bereitet, die die Metallanteile in den Atomverhältnissen des Supraleiters enthält, man durch Vereinigung mit einer Oxalsäurelösung die Metalle als Oxalat ausfällt, man das Gemisch der Oxalate abtrennt, trocknet, zu den Oxiden zersetzt und anschließend in Gegenwart von Sauerstoff bei Temperaturen von 700 bis 900°C sintert und in den Supraleiter überführt, dadurch gekennzeichnet, daß das Erhitzen des Metalloxalats bei 200 bis 400°C in einer Gasatmosphäre durchgeführt wird, die einen O₂-Partialdruck von 0 bis 5 mbar aufweist, und das Erhitzen des daraus gebildeten oxidhaltigen Pulvers bis 700°C in einer Gasatmosphäre mit einem Sauerstoffpartialdruck von 1 bis 50 mbar in Anwesenheit eines Inertgases und bei einem Absolutdruck im Bereich von 0,5 bis 2 bar erfolgt.

3. Verfahren nach Anspruch 1 oder 2, dadurch gekennzeichnet, daß man eine Lösung einsetzt, die die Metallanteile Y:Ba:Cu als Kationen in einem Atomverhältnis von 1:2:3 enthält.

4. Verfahren nach einem der Ansprüche 1 bis 3, dadurch gekennzeichnet, daß als Inertgas Argon oder Stickstoff eingesetzt wird und daß das Erhitzen bei einem Absolutdruck im Bereich von 0,8 bis 1,2 bar erfolgt.

## Claims

1. A process for the preparation of a phase-pure, copper-containing, ceramic oxide superconductor which contains, in addition to copper, at least one alkaline earth metal from the group comprising Ba, Sr and Ca, and at least one metal from the group comprising Y, La, Tl, Pb and the rare earths, in which a solution is prepared which contains the metal components in the atomic ratios of the superconductor, the metals are precipitated as oxalates by combining this solution with an oxalic acid solution, the mixture of the oxalates is separated off, dried and decomposed to form the oxides, and the latter are subsequently sintered at temperatures of from 700 to 900°C in the presence of oxygen and converted into the superconductor, which comprises carrying out the heating of the metal oxalates and the oxides formed therefrom at up to 700°C at an oxygen partial pressure of 5 to 50 mbar, in the presence of an inert gas and at an absolute pressure in the range from 0.5 to 2 bar.

2. A process for the preparation of a phase-pure, copper-containing, ceramic oxide superconductor which contains, in addition to copper, at least one alkaline earth metal from the group comprising Ba, Sr and Ca, and at least one metal from the group comprising Y, La, Tl, Pb and the rare earths, in which a solution is prepared which contains the metal components in the atomic ratios of the superconductor, the metals are precipitated as oxalates by combining this solution with an oxalic acid solution, the mixture of the oxalates is separated off, dried and decomposed to form the oxides, and the latter are subsequently sintered at temperatures of from 700 to 900°C in the presence of oxygen and converted into the superconductor, which comprises carrying out the heating of the metal oxalates at 200 to 400°C in a gas atmosphere which has an O₂ partial pressure of from 0 to 5 mbar, and carrying out the heating of the oxide-containing powder formed therefrom at up to 700°C in a gas atmosphere having an oxygen partial pressure from 1 to 50 mbar, in the presence of an inert gas and at an absolute pressure in the range from 0.5 to 2 bar.

3. The process as claimed in claim 1 or 2, wherein a solution is employed which contains the metal components Y:Ba:Cu as cations in an atomic ratio of 1:2:3.

4. The process as claimed in one of claims 1 to 3, wherein the inert gas employed is argon or nitrogen and wherein the heating is carried out at an absolute pressure in the range from 0.8 to 1,2 bar.

## Revendications

1. Procédé de préparation d'un supraconducteur formé d'oxydes céramiques contenant du cuivre et en phase pure, qui contient, en plus du cuivre, au moins encore un métal alcalino terreux choisi dans l'ensemble formé par Ba, Sr, Ca et au moins un métal de l'ensemble formé par Y, La, Tl, Pb ou les terres rares, procédé selon lequel on prépare une solution qui contient les constituants métalliques selon les rapports atomiques du supraconducteur, on soumet après combinaison avec une solution d'acide oxalique à une précipitation des métaux sous forme d'oxalates, on sépare le mélange des oxalates, on le sèche, on le décompose en les oxydes, puis on le fritte en présence d'oxygène à des températures de 700 à 900°C et on le transforme en les supraconducteurs, procédé caractérisé en ce que le chauffage de l'oxalate de métal et des oxydes formés à partir de celui-ci a lieu jusqu'à 700°C sous une pression partielle d'oxygène de 5 à 50 mbars en présence d'un gaz inerte et sous une pression absolue comprise entre 0,5 et 2 bars.

2. Procédé de préparation d'un supraconducteur formé d'oxydes céramiques contenant du cuivre et en phase pure, et qui, en plus du cuivre, contient au moins encore un métal alcalino terreux choisi parmi Ba, Sr, Ca et au moins un métal choisi parmi Y, La, Tl, Pb et les terres rares, procédé selon lequel on prépare une solution qui contient les constituants métalliques selon les rapports entre atomes du supraconducteur, on provoque, après combinaison avec une solution d'acide oxalique, la précipitation des métaux sous forme d'oxalates, on sépare le mélange des oxalates, on le sèche, on le décompose en les oxydes, puis on le fritte en présence d'oxygène à des températures de 700 à 900°C et on le transforme en le supraconducteur, procédé caractérisé en ce qu'on conduit le chauffage de l'oxalate de métal à 200 jusqu'à 400°C dans une atmosphère de gaz présentant une pression partielle de O₂ de 0 à 5 mbars, et l'on effectue le chauffage de la poudre contenant des oxydes, ainsi formée, jusqu'à 700°C dans une atmosphère de gaz présentant une pression partielle d'oxygène de 1 à 50 mbars, en opérant en présence d'un gaz inerte et sous une pression absolue se situant entre 0,5 et 2 bars.

3. procédé selon la revendication 1 ou 2, caractérisé en ce qu'on utilise une solution qui contient les constituants métalliques Y:Ba:Cu sous forme de cations présentant un rapport entre les atomes de 1:2:3.

4. Procédé selon une des revendications 1 à 3, caractérisé en ce qu'on utilise comme gaz inerte l'argon ou l'azote et en ce qu on effectue le chauffage sous une pression absolue se situant entre 0,8 et 1,2 bar.
